# EUROPEAN PATENT APPLICATION

(11) **EP 4 770 406 A1**
(43) Date of publication of application: **01.07.2026**
(21) Application number: 25226968.3
(22) Date of filing: 23.12.2025
(51) Int. Cl.: H10W 20/41, H10W 20/40, H01F 17/00

(54) **INTEGRATED CIRCUIT STRUCTURE**

(30) Priority: 26.12.2024 US 202463738894 P; 22.12.2025 US 202519428888
(71) Applicant: MediaTek Inc., Hsinchu City 30078 (TW)
(72) Inventor: LI, Po-Jui, 30078 Hsinchu City (TW); SUN, Ruey-Bo, 30078 Hsinchu City (TW); LIU, Tsz-Bin, 30078 Hsinchu City (TW); ABDULLATIF, Mohammed Mohsen Abdulsalam, San Jose (US); LIN, Sheng-Mou, 30078 Hsinchu City (TW)
(74) Representative: Haseltine Lake Kempner LLP

(57) **Abstract**

An integrated circuit structure is provided. The integrated circuit structure includes a substrate, a patterned ground shield structure, and a shielded circuit. The patterned ground shield structure is disposed above the substrate. The patterned ground shield structure includes a central portion and branches. The branches are connected to the central portion. The branches substantially extend radially from a central point of the central portion and surround the central portion. The shielded circuit including at least one conductive line is located directly above the patterned ground shield structure.

## Description

### CROSS REFERENCE TO RELATED APPLICATIONS

This application claims the benefit of U.S. provisional application No. 63/738,894, filed on December 26, 2024, the entirety of which is incorporated by reference herein.

### TECHNICAL FIELD

The present disclosure relates to an integrated circuit structure, and, in particular, it relates to a patterned ground shield structure for a vulnerable inductive circuit.

### BACKGROUND

In analog integrated circuits (IC), unwanted electric or magnetic fields from other circuits can interfere with the IC. Inductive circuits are especially vulnerable because they can easily receive electromagnetic (EM) fields. This kind of interference or coupling will cause unexpected errors in the circuit. Conventionally, the most effective way to prevent EM coupling is to add ground shields to those vulnerable circuits. However, conventional ground shields are too solid and will generate eddy currents, hurting the quality factor (Q factor) of the inductive circuit, which is a key factor in analog ICs.

Thus, a novel ground shield is desirable.

### BRIEF SUMMARY

An embodiment of the present disclosure provides an integrated circuit structure. The integrated circuit structure includes a substrate, a patterned ground shield structure, and a shielded circuit. The patterned ground shield structure is disposed above the substrate. The patterned ground shield structure includes a central portion and branches. The branches are connected to the central portion. The branches substantially extend radially from a central point of the central portion and surround the central portion. The shielded circuit including at least one conductive line is located directly above the patterned ground shield structure.

An embodiment of the present disclosure provides an integrated circuit structure. The integrated circuit structure includes a substrate, a comb-shaped ground shield structure, and a shielded circuit. The comb-shaped ground shield structure disposed above the substrate. The comb-shaped ground shield structure includes a solid rib portion, first teeth and second teeth. The first teeth are arranged on a first side of the solid rib portion. The second teeth are arranged on a second side of the solid rib portion. The shielded circuit is located directly above the patterned ground shield structure. In a top view, an edge of a coil of the shielded circuit is around the solid rib portion.

### BRIEF DESCRIPTION OF THE DRAWINGS

The present disclosure can be more fully understood by reading the subsequent detailed description and examples with references made to the accompanying drawings, wherein:
FIG. 1 is a schematic top view of an integrated circuit structure in accordance with some embodiments of the disclosure;
FIG. 2 is a schematic cut-away view of the integrated circuit structure of FIG. 1 in accordance with some embodiments of the disclosure;
FIG. 3 is a schematic top view of a patterned ground shield structure of an integrated circuit structure in accordance with some embodiments of the disclosure;
FIG. 4 is a schematic top view of an integrated circuit structure in accordance with some embodiments of the disclosure; and
FIGS. 5A, 5B, 5C, 5D, 5E, 5F, 5G, 5H and 5I are schematic top views of patterned ground shield structures of an integrated circuit structure in accordance with some embodiments of the disclosure.

### DETAILED DESCRIPTION

The following description is made for the purpose of illustrating the general principles of the disclosure and should not be taken in a limiting sense. The scope of the disclosure is best determined by reference to the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

One way to prevent the inductive circuit from EM coupling and keep the quality factor of the inductive circuit is moving the aggressors (EM coupling source) far away from the vulnerable circuit. However, in the future, it is supposed that the inductive circuit size will become smaller and smaller, so it will be important if the coupling can be eliminated without expanding the circuit dimension. Moreover, sometimes it is very hard to find out the EM coupling source. In some cases, the unwanted EM field is everywhere in the system. Another way is applying the ground shield to the vulnerable circuit. However, if the vulnerable circuit contains inductive element, the quality factor (Q factor) will degrade significantly because of the ground shield. It is not acceptable in analog circuit which need a high Q performance. Thus, a novel patterned ground structure that can effectively prevent the EM coupling, hardly generate eddy current, and keep the quality factor of the inductive circuit is desirable.

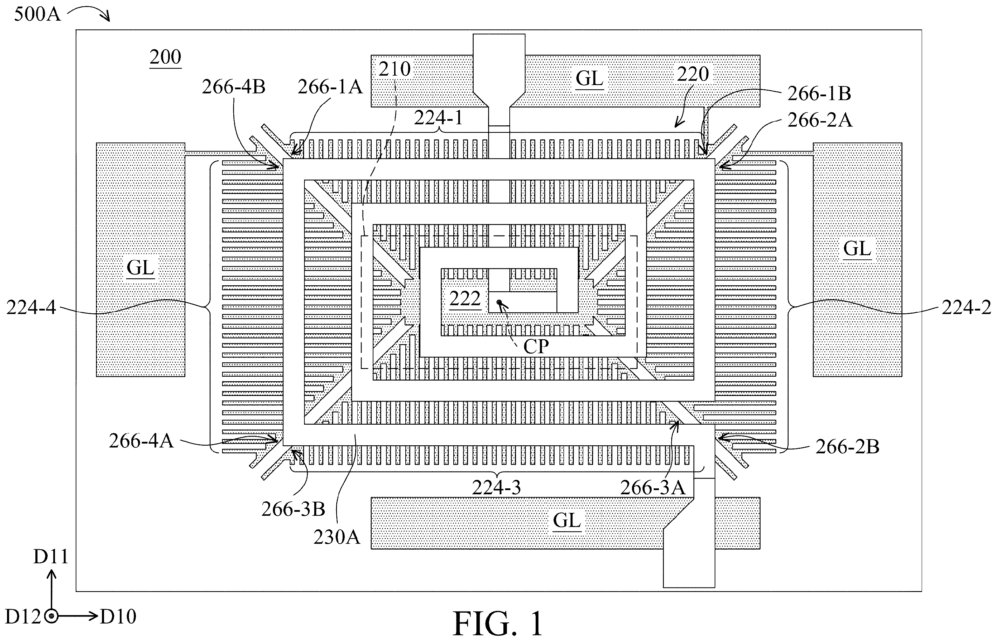

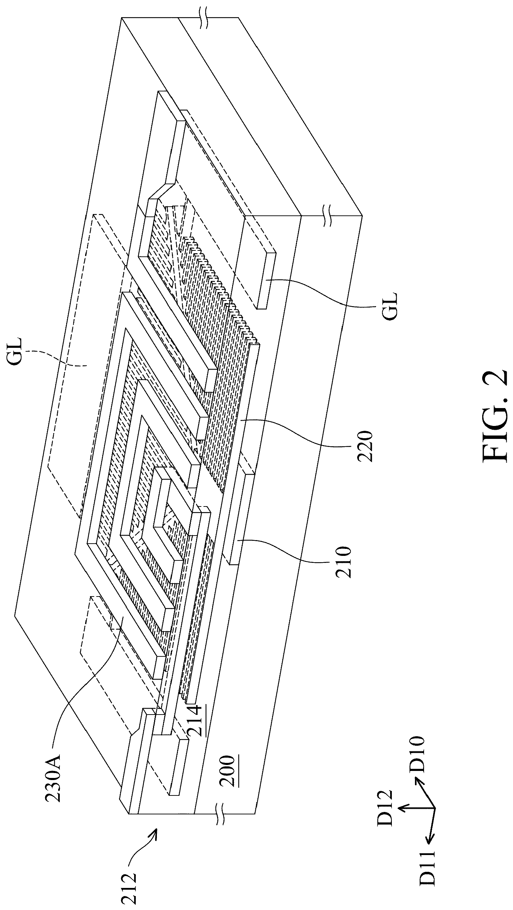

FIG. 1 is a schematic top view of an integrated circuit structure 500A in accordance with some embodiments of the disclosure. FIG. 2 is a schematic cut-away view of the integrated circuit structure 500A of FIG. 1 in accordance with some embodiments of the disclosure. In some embodiments as shown in FIGS. 1 and 2, the integrated circuit structure 500A may include a substrate 200, an aggressor circuit 210, a patterned ground shield (PGS) structure 220 and a shielded circuit 230A. It is noted that FIG. 1 only shows he substrate 200, the aggressor circuit 210, the patterned ground shield (PGS) structure 220 and the shielded circuit 230A for illustration, the remaining features may be shown in the schematic cross-sectional views of FIG. 2.

In some embodiments, the substrate 200 such as a semiconductor substrate may include silicon. In alternative embodiments, SiGe, bulk semiconductor, strained semiconductor, compound semiconductor, semiconductor-on-insulator (SOI), and other commonly used semiconductor substrates can be used for the semiconductor substrate 200.

In some embodiments, the integrated circuit structure 500A may further include a dielectric layer 214 formed on the substrate 200. The dielectric layer 214 may belong to an interconnection structure 212. In some embodiments, the interlayer dielectric layer 214 may include a single layer structure or a multi-layer structure. In some embodiments, the interlayer dielectric layer 214 may include silicon oxide, silicon oxynitride, un-doped silicate glass (USG), borosilicate glass (BSG), phosphoric silicate glass (PSG), borophosphosilicate glass (BPSG), fluorinated silicate glass (FSG), carbon doped oxide, porous carbon doped silicon dioxide, a polymer such as polyimide or silicon oxycarbide polymer (SiOC), or combinations thereof.

In some embodiments, the aggressor circuit 210 and the shielded circuit 230A are disposed on the substrate 200. For example, the aggressor circuit 210 is disposed on the substrate 200 and covered by the dielectric layer 214. The shielded circuit 230A is disposed on the dielectric layer 214. The shielded circuit 230A may include at least one conductive line (e.g., a metal line) of the interconnection structure 212. In some embodiments, the aggressor circuit 210 and the shielded circuit 230A may overlap each other in the direction D12 that is vertical to the top surface 200T of the substrate 200. It may be noted that the position of the aggressor circuit 210 is not limited to what is illustrated in FIG. 2. In other words, the aggressor circuit 210 may be placed in other regions of the substrate 200, or even not in the substrate 200 but in another device such as a nearby semiconductor chip.

In some embodiments, the aggressor circuit 210 described herein refers to a circuit that generates capacitive or inductive noise (also serve as an electric-magnetic (EM) coupling source) interfering with the operation of another circuit. The shielded circuit 230A described herein refers to a circuit subject to interference from the noise generated by the aggressor circuit 210.

In some embodiments, the shielded circuit 230A may be, for example, an inductor (including a spiral inductor, an O-shaped inductor or an 8-shaped inductor) or a transformer. For example, the shielded circuit 230A shown in FIG. 1 is a spiral inductor. In some embodiments, the aggressor circuit 210 may be, for example, an inductive circuit or a wireless communication circuit. For example, the aggressor circuit 210 is an inductive circuit.

In embodiments as shown in FIG. 2, the patterned ground shield structure 220 is disposed above the substrate 200. In addition, the patterned ground shield structure 220 is disposed in the dielectric layer 214 and located between the aggressor circuit 210 and the shielded circuit 230A. More specifically, the shielded circuit 230A is located directly above the patterned ground shield structure 220, and the aggressor circuit 210 is located directly below the patterned ground shield structure 220. In some embodiments, the patterned ground shield structure 220 may be composed of one or more conductive layers (or further composed of one or more vias) at one or more levels of the interconnection structure. In some embodiments, the patterned ground shield structure 220 may be formed of metal.

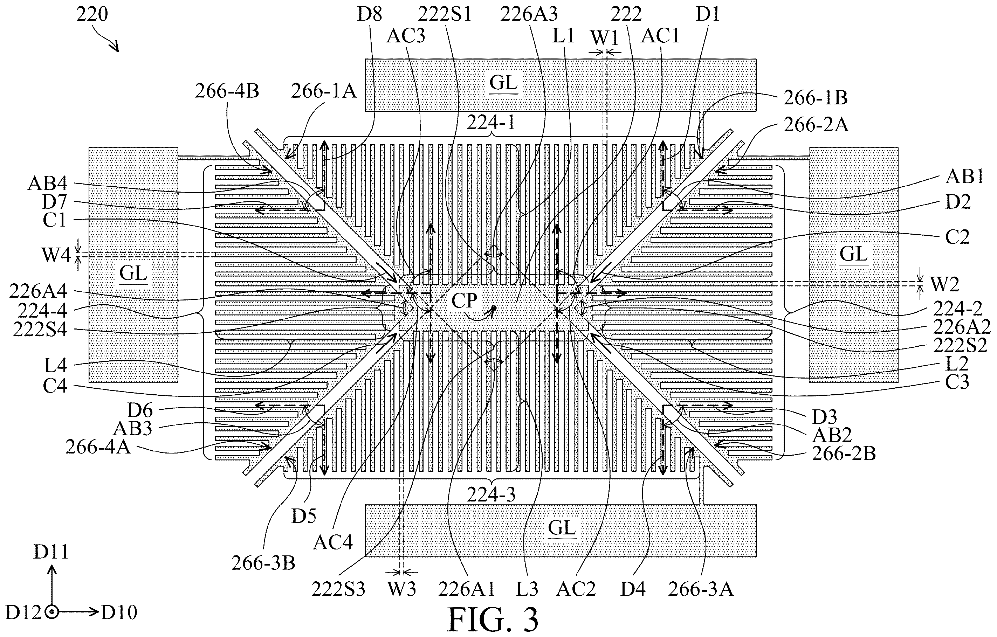

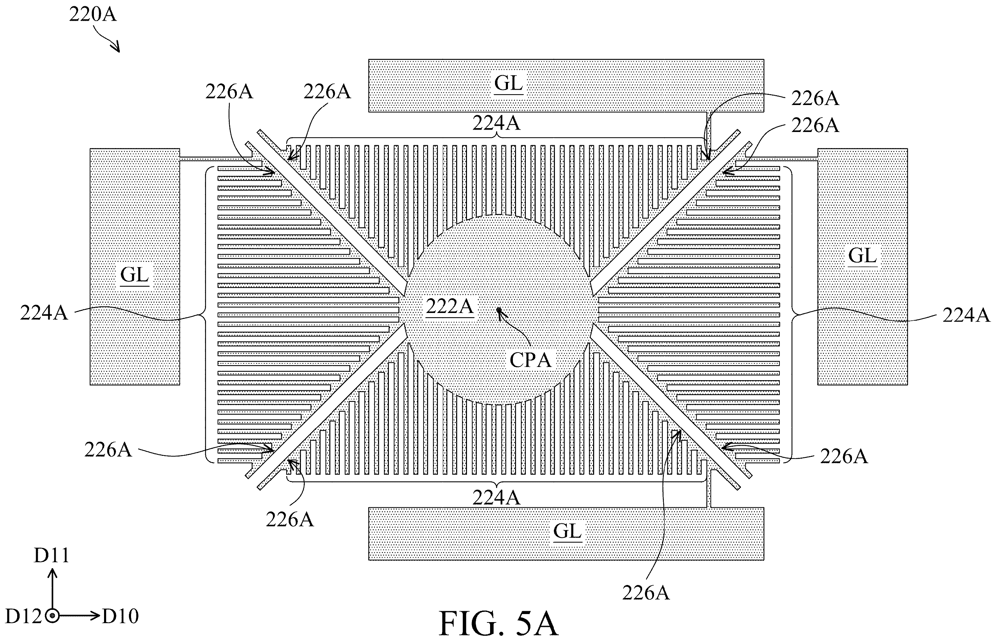

FIG. 3 is a schematic top view of the patterned ground shield structure 220 (including patterned ground shield structures 220A, 220B, 220C, 220D, 220E, 220F, 220G, 220H, and 220I shown in FIGS. 5A-5I) of the integrated circuit structure 500A in accordance with some embodiments of the disclosure. In some embodiments, the patterned ground shield structure 220 may located at a single conductive layered level of the interconnection structure. As shown in FIG. 3, the patterned ground shield structure 220 may include a central portion 222 (including central portions 222A, 222B, 222C, 222D, 222E, 222F, 222G, 222H, and 222I shown in FIGS. 5A-5I), a group of branches 224-1, a group of branches 224-2, a group of branches 224-3 and a group of branches 224-4.

The central portion 222 may be a solid conductive portion without any slot or hole in it. In some embodiment as shown in FIG. 3, the central portion 222 may have a rectangular shape having four sides 222S1, 222S2, 222S3, and 222S4 and four corners C1, C2, C3, and C4. The side 222S1 is located between corners C1 and C2, the side 222S2 is located between corners C2 and C3, the side 222S3 is located between corners C3 and C4, and the side 222S4 is located between corners C4 and C1. The parallel sides 222S1 and 222S3 may extend along the direction D10, and the parallel sides 222S2 and 222S4 may extend along the direction D11.

The group of branches 224-1, the group of branches 224-2, the group of branches 224-3, and the group of branches 224-4 are connected to the sides 222S1, 222S2, 222S3, and 222S4 of the central portion 222. In some embodiments, the branches 224-1 to 224-4 may substantially extend radially from the central point CP of the central portion 222 and surround the central portion 222.

For example, as shown in FIG. 3, the group of branches 224-1 is arranged on the side 222S1 of the central portion 222 and extending outward from the central portion 222.

In some embodiments, the branches 224-1 may extend along a first direction D1 and are arranged along a second direction D2 different from the first direction D1. In some embodiments, the angle AB1 between the first direction D1 and the second direction D2 may be greater than zero degrees and less than 90 degrees. In addition, the second direction D2 may be parallel to the extending direction of the side 222S1 of the central portion 222 connected to the branches 224-1. For example, the branches 224-1 may extend along the direction D10 and are arranged along the direction D11 that is perpendicular to the direction D10 (i.e., the first direction D1 is parallel to the direction D10, the second direction D2 is parallel to the direction D11, and the angle AB1 is 90 degrees). In addition, the direction D11 is parallel to the extending direction of the side 222S1 of the central portion 222 connected to the branches 224-1. In some embodiments, the branches 224-1 may be parallel each other.

In some embodiments, the angle AC1 between the extending direction (the first direction D1 (e.g., the direction D10)) of the branches 224-1 and the extending direction (e.g., the direction D11) of the side 222S1 of the central portion 222 connected to the branches 224-1 may be greater than zero degrees and less than 180 degrees. For example, the angle AC1 is 90 degrees (i.e., the extending direction (e.g., the direction D10) of the branches 224-1 is perpendicular to the extending direction (e.g., the direction D11) of the side 222S1 of the central portion 222 connected to the branches 224-1).

In some embodiments, the length L1 of the branches 224-1 directly connected to (overlapping) the side 222S1 of central portion 222 may have the same value. In some embodiments, the width W1 of the branches 224-1 may have the same or different values. In some embodiments, the spacing (not shown) between the branches 224-1 may be the same as the minimum metal spacing according to the design rule.

As shown in FIG. 3, the group of branches 224-2 is arranged on the side 222S2 of the central portion 222 and extending outward from the central portion 222.

In some embodiments, the branches 224-2 may extend along a third direction D3 and are arranged along a fourth direction D4 different from the third direction D3. In some embodiments, the angle AB2 between the third direction D3 and the fourth direction D4 may be greater than zero degrees and less than 90 degrees. In addition, the fourth direction D4 may be parallel to the extending direction of the side 222S2 of the central portion 222 connected to the branches 224-2. For example, the branches 224-2 may extend along the direction D11 and are arranged along the direction D10 that is perpendicular to the direction D11 (i.e., the third direction D3 is parallel to the direction D11, the fourth direction D4 is parallel to the direction D10, and the angle AB2 is 90 degrees). In addition, the direction D10 is parallel to the extending direction of the side 222S2 of the central portion 222 connected to the branches 224-2. In some embodiments, the branches 224-2 may be parallel each other.

In some embodiments, the angle between the extending direction (the first direction D1 (e.g., the direction D10)) of the branches 224-1 and the extending direction (the third direction D3 (e.g., the direction D11)) of the branches 224-2 corresponds to the angle of the corner C2 (e.g., 90 degrees) between the sides 222S1 and 222S2 of the central portion 222.

In some embodiments, the angle AC2 between the extending direction (the third direction D3 (e.g., the direction D11)) of the branches 224-2 and the extending direction (e.g., the direction D10) of the side 222S2 of the central portion 222 connected to the branches 224-2 may be greater than zero degrees and less than 180 degrees. For example, the angle AC2 is 90 degrees (i.e., the extending direction (e.g., the direction D11) of the branches 224-2 is perpendicular to the extending direction (e.g., the direction D10) of the side 222S2 of the central portion 222 connected to the branches 224-2).

In some embodiments, the length L2 of the branches 224-2 directly connected to (overlapping) the side 222S2 of central portion 222 may have the same value. In some embodiments, the width W2 of the branches 224-2 may have the same or different values. In some embodiments, the spacing (not shown) between the branches 224-2 may be the same as the minimum metal spacing according to the design rule.

In some embodiments, the branches 224-1 directly connected to (overlapping) the side 222S1 of the central portion 222 and the branches 224-2 directly connected to (overlapping) the side 222S2 of the central portion 222 may have the same or different lengths (i.e., L1=L2, L1>L2 ,or L1<L2).

In some embodiments, the patterned ground shield structure 220 further includes the group of branches 224-3 is arranged on the side 222S3 of the central portion 222 and extending outward from the central portion 222.

In some embodiments, the branches 224-3 may extend along a fifth direction D5 and are arranged along a sixth direction D6 different from the fifth direction D5. In some embodiments, the angle AB3 between the fifth direction D5 and the sixth direction D6 may be greater than zero degrees and less than 90 degrees. In addition, the sixth direction D6 may be parallel to the extending direction of the side 222S3 of the central portion 222 connected to the branches 224-3. For example, the branches 224-3 may extend along the direction D10 and are arranged along the direction D11 that is perpendicular to the direction D10 (i.e., the fifth direction D5 is parallel to the direction D10, the sixth direction D6 is parallel to the direction D11, and the angle AB3 is 90 degrees). In addition, the direction D11 is parallel to the extending direction of the side 222S3 of the central portion 222 connected to the branches 224-3. In some embodiments, the branches 224-3 may be parallel each other.

In some embodiments, the angle between the extending direction (the third direction D3 (e.g., the direction D11)) of the branches 224-2 and the extending direction (the fifth direction D5 (e.g., the direction D10)) of the branches 224-3 corresponds to the angle of the corner C3 (e.g., 90 degrees) between the sides 222S2 and 222S3 of the central portion 222.

In some embodiments, the angle AC3 between the extending direction (the fifth direction D5 (e.g., the direction D10)) of the branches 224-3 and the extending direction (e.g., the direction D11) of the side 222S3 of the central portion 222 connected to the branches 224-3 may be greater than zero degrees and less than 180 degrees. For example, the angle AC3 is 90 degrees (i.e., the extending direction (e.g., the direction D10) of the branches 224-3 is perpendicular to the extending direction (e.g., the direction D11) of the side 222S3 of the central portion 222 connected to the branches 224-3).

In some embodiments, the length L3 of the branches 224-3 directly connected to (overlapping) the side 222S3 of central portion 222 may have the same value. In some embodiments, the width W3 of the branches 224-3 may have the same or different values. In some embodiments, the spacing (not shown) between the branches 224-3 may be the same as the minimum metal spacing according to the design rule.

In some embodiments, the branches 224-1 directly connected to the side 222S1, the branches 224-2 overlapping the side 222S2, and the branches 224-3 overlapping the side 222S3 of the central portion 222 may have the same or different lengths.

In some embodiments, the patterned ground shield structure 220 further includes the group of branches 224-4 is arranged on the side 222S4 of the central portion 222 and extending outward from the central portion 222.

In some embodiments, the branches 224-4 may extend along a seventh direction D7 and are arranged along an eighth direction D8 different from the seventh direction D7. In some embodiments, the angle AB4 between the seventh direction D7 and the eighth direction D8 may be greater than zero degrees and less than 90 degrees. In addition, the eighth direction D8 may be parallel to the extending direction of the side 222S4 of the central portion 222 connected to the branches 224-4. For example, the branches 224-4 may extend along the direction D11 and are arranged along the direction D10 that is perpendicular to the direction D11 (i.e., the seventh direction D7 is parallel to the direction D11, the eighth direction D8 is parallel to the direction D10, and the angle AB4 is 90 degrees). In addition, the direction D10 is parallel to the extending direction of the side 222S4 of the central portion 222 connected to the branches 224-4. In some embodiments, the branches 224-4 may be parallel each other.

In some embodiments, the angle between the extending direction (the fifth direction D5 (e.g., the direction D10)) of the branches 224-3 and the extending direction (the seventh direction D7 (e.g., the direction D11)) of the branches 224-4 corresponds to the angle of the corner C4 (e.g., 90 degrees) between the sides 222S3 and 222S4 of the central portion 222.

In some embodiments, the angle between the extending direction (the seventh direction D7 (e.g., the direction D11)) of the branches 224-4 and the extending direction (the first direction D1 (e.g., the direction D10)) of the branches 224-1 corresponds to the angle of the corner C1 (e.g., 90 degrees) between the sides 222S4 and 222S1 of the central portion 222.

In some embodiments, the angle AC4 between the extending direction (the seventh direction D7 (e.g., the direction D11)) of the branches 224-4 and the extending direction (e.g., the direction D10) of the side 222S4 of the central portion 222 connected to the branches 224-4 may be greater than zero degrees and less than 180 degrees. For example, the angle AC4 is 90 degrees (i.e., the extending direction (i.e., the extending direction (e.g., the direction D11) of the branches 224-4 is perpendicular to the extending direction (i.e., the extending direction (e.g., the direction D10) of the side 222S4 of the central portion 222 connected to the branches 224-4).

In some embodiments, the length L4 of the branches 224-4 directly connected to (overlapping) the side 222S4 of central portion 222 may have the same value. In some embodiments, the width W4 of the branches 224-4 may have the same or different values. In some embodiments, the spacing (not shown) between the branches 224-4 may be the same as the minimum metal spacing according to the design rule.

In some embodiments,, the branches 224-1 directly connected to the side 222S1, the branches 224-2 overlapping the side 222S2, the branches 224-3 overlapping the side 222S3, and the branches 224-4 overlapping the side 222S4 of the central portion 222 may have the same or different lengths.

In some embodiments, when the central portion 222 has a polygonal shape, the number of groups of branches may correspond to (the same as) the number of sides of the central portion 222 of the patterned ground shield structure 220. For example, when the central portion 222 has a rectangular shape, the patterned ground shield structure 220 may have four groups of branches (e.g., the branches 224-1, the branches 224-2, the branches 224-3, and, the branches 224-4).

In some embodiments, the patterned ground shield structure 220 further includes separated supporting bars 266-1A and 266-1B. As shown in FIG. 3, the supporting bar 266-1A is connected to the central portion 222 close to the corner C1 and extending outward from the central portion 222. The supporting bar 266-1B is connected to the central portion 222 close to the corner C2 and extending outward from the central portion 222. In some embodiments, at least one of the supporting bars 266-1A and 266-1B is coupled to a ground layer GL. In some embodiments, the ground layer GL may also belong to a conductive layer of the interconnect structure 212. In some embodiments, various branches of the patterned ground shield structure 220 in a same group may share certain supporting bars and coupled to a same ground layer GL. It may be worth noting that, in certain embodiments such as illustrated in FIG.3, each group of the branches 224-1, 224-2, 224-3, 224-4 is coupled to a corresponding ground layer GL, but the present disclosure is not limited thereto. For instance, various groups of the branches 224-1, 224-2, 224-3, 224-4 may be coupled to a same ground layer GL.

In some embodiments, the patterned ground shield structure 220 and the ground layer GL are located at the same or different levels. For example, the patterned ground shield structure 220 and the ground layer GL may be located at the same level. For example, the patterned ground shield structure 220 may be located above or below the ground layer GL.

In some embodiments, the branches 224-1 are sandwiched between the supporting bars 266-1A and 266-1B. More specifically, the branches 224-1 not directly connected to (overlapping) the side 222S1 of the central portion 222 are directly connected to the supporting bars 266-1A and 266-1B. In addition, the lengths L1 of the branches 224-1 connected to the supporting bars 266-1A and 266-1B are gradually changed. For example, the lengths L1 of the branches 224-1 connected to the supporting bars 266-1A and 266-1B are gradually decreased outwardly.

In some embodiments, the angle 226A1 between the supporting bars 266-1A and 266-1B is greater than zero degrees and less than 90 degrees.

In some embodiments, the patterned ground shield structure 220 further includes separated supporting bars 266-2A and 266-2B. As shown in FIG. 3, the supporting bar 266-2A is connected to the central portion 222 close to the corner C2 and extending outward from the central portion 222. The supporting bar 266-2B is connected to the central portion 222 close to the corner C3 and extending outward from the central portion 222. In some embodiments, at least one of the supporting bars 266-2A and 266-2B is coupled to a ground layer GL.

In some embodiments, the supporting bars 266-1B and 266-2A connected to the central portion 222 close to the corner C2 are separated from and parallel to each other.

In some embodiments, the branches 224-2 are sandwiched between the supporting bars 266-2A and 266-2B. More specifically, the branches 224-2 not directly connected to (overlapping) the side 222S2 of the central portion 222 are directly connected to the supporting bars 266-2A and 266-2B. In addition, the lengths L2 of the branches 224-2 connected to the supporting bars 266-2A and 266-2B are gradually changed. For example, the lengths L2 of the branches 224-2 connected to the supporting bars 266-2A and 266-2B are gradually decreased outwardly.

In some embodiments, the angle 226A2 between the supporting bars 266-2A and 266-2B is greater than zero degrees and less than 90 degrees.

In some embodiments, the patterned ground shield structure 220 further includes separated supporting bars 266-3A and 266-3B. As shown in FIG. 3, the supporting bar 266-3A is connected to the central portion 222 close to the corner C3 and extending outward from the central portion 222. The supporting bar 266-3B is connected to the central portion 222 close to the corner C4 and extending outward from the central portion 222. In some embodiments, at least one of the supporting bars 266-3A and 266-3B is coupled to a ground layer GL.

In some embodiments, the supporting bars 266-2B and 266-3A connected to the central portion 222 close to the corner C3 are separated from and parallel to each other.

In some embodiments, the branches 224-3 are sandwiched between the supporting bars 266-3A and 266-3B. More specifically, the branches 224-3 not directly connected to (overlapping) the side 222S3 of the central portion 222 are directly connected to the supporting bars 266-3A and 266-3B. In addition, the lengths L3 of the branches 224-3 connected to the supporting bars 266-3A and 266-3B are gradually changed. For example, the lengths L3 of the branches 224-3 connected to the supporting bars 266-3A and 266-3B are gradually decreased outwardly.

In some embodiments, the angle 226A3 between the supporting bars 266-3A and 266-3B is greater than zero degrees and less than 90 degrees.

In some embodiments, the patterned ground shield structure 220 further includes separated supporting bars 266-4A and 266-4B. As shown in FIG. 3, the supporting bar 266-4A is connected to the central portion 222 close to the corner C4 and extending outward from the central portion 222. The supporting bar 266-4B is connected to the central portion 222 close to the corner C1 and extending outward from the central portion 222. In some embodiments, at least one of the supporting bars 266-4A and 266-4B is coupled to a ground layer GL.

In some embodiments, the supporting bars 266-3B and 266-4A connected to the central portion 222 close to the corner C4 are separated from and parallel to each other. The supporting bars 266-4B and 266-1A connected to the central portion 222 close to corner C1 are separated from and parallel to each other.

In some embodiments, the branches 224-4 are sandwiched between the supporting bars 266-4A and 266-4B. More specifically, the branches 224-4 not directly connected to (overlapping) the side 222S4 of the central portion 222 are directly connected to the supporting bars 266-4A and 266-4B. In addition, the lengths L4 of the branches 224-4 connected to the supporting bars 266-4A and 266-4B are gradually changed. For example, the lengths L4 of the branches 224-4 connected to the supporting bars 266-4A and 266-4B are gradually decreased outwardly.

In some embodiments, the angle 226A4 between the supporting bars 266-4A and 266-4B is greater than zero degrees and less than 90 degrees.

As shown in FIGS. 1 and 2, the shielded circuit 230A, such as a spiral inductor, including at least one conductive line is located directly above the patterned ground shield structure 220. In some embodiments, the at least one conductive line (the coil of the spiral inductor) overlaps the branches 224-1 to 224-4 of the patterned ground shield structure 220.

In some embodiments, in a top view as shown in FIG. 1, in order to maintain the quality factor of the aggressor circuit 210, the area of the central portion 222 is smaller than the area of the aggressor circuit 210.

As shown in FIG. 1, a vertical projection of the central point CP of the central portion 222 on the substrate 200 is located within a vertical projection of the coil of the shielded circuit 230A (the spiral inductor) on the substrate 200. In a top view as shown in FIG. 1, an outer edge of the coil of the shielded circuit 230A (the spiral inductor) is around the central portion 222. In addition, the vertical projection of the coil of the shielded circuit 230A on the substrate 200 may surround portions of the branches 224-1 to 224-4 of the patterned ground shield structure 220.

In some embodiments, the extending direction of the branches 224-1 to 224-4 may be substantially parallel to the tangent line direction of the corresponding linear segments of coil of the shielded circuit 230A (the spiral inductor).

In another aspect, the patterned ground shield structure 220 may have a comb-shape and can serve as a comb-shaped ground shield structure 220. The central portion 222 may serve as a solid rib portion 222 of the comb-shaped ground shield structure 220. The branches 224-1 to 224-4 may serve as teeth 224-1 to 224-4 of the comb-shaped ground shield structure 220. The teeth 224-1 to 224-4 are arranged on and connected to the sides 222S1 to 222S4 of the solid rib portion 222, respectively.

In some embodiments, the angles AC1 to AC4 between the extending direction of the branches 224-1 to 224-4 and the extending direction of the sides 222S1 to 222S4 of the central portion 222 connected to the branches 224-1 to 224-4 and may also serve as the angles AC1 to AC4 between the teeth 224-1 to 224-4 and the sides 222S1 to 222S4 of the central portion 222 connected to the branches 224-1 to 224-4. In some embodiments, the angles AC1 to AC4 is e greater than zero degrees and less than 180 degrees. For example, the teeth 224-1 are perpendicular to the side 222S1 of the solid rib portion 222 (i.e., the angle AC1 is 90 degrees). The teeth 224-2 are perpendicular to the side 222S2 of the solid rib portion 222 (i.e., the angle AC2 is 90 degrees). The teeth 224-3 are perpendicular to the side 222S3 of the solid rib portion 222 (i.e., the angle AC3 is 90 degrees). The teeth 224-4 are perpendicular to the side 222S4 of the solid rib portion 222 (i.e., the angle AC4 is 90 degrees).

In some embodiments, the comb-shaped ground shield structure 220 further includes separated supporting bars 266-1A, 266-1B, 266-2A, 266-2B, 266-3A, 266-3B, 266-4A, and 266-4B connected to the corners C1 to C4 of the comb-shaped ground shield structure 220. The teeth 224-1 not directly connected to (overlapping) the side 222S1 of the solid rib portion 222 are directly connected to the supporting bars 266-1A and 266-1B. The teeth 224-2 not directly connected to (overlapping) the side 222S2 of the solid rib portion 222 are directly connected to the supporting bars 266-2A and 266-2B. The teeth 224-3 not directly connected to (overlapping) the side 222S3 of the solid rib portion 222 are directly connected to the supporting bars 266-3A and 266-3B. The teeth 224-4 not directly connected to (overlapping) the side 222S2 of the solid rib portion 222 are directly connected to the supporting bars 266-4A and 266-4B.

In some embodiments, the supporting bars 266-4B and 266-1A connected to the same corner C1 of the solid rib portion 222 may be substantially parallel to the internal angle bisector of the corner C1. The supporting bars 266-1B and 266-2A connected to the same corner C2 of the solid rib portion 222 may be substantially parallel to the internal angle bisector of the corner C2. The supporting bars 266-2B and 266-3A connected to the same corner C3 of the solid rib portion 222 may be substantially parallel to the internal angle bisector of the corner C3. The supporting bars 266-3B and 266-4A connected to the same corner C4 of the solid rib portion 222 may be substantially parallel to the internal angle bisector of the corner C4.

In some embodiments, a vertical projection of the central point CP of the solid rib portion 222 on the substrate 200 is located within a vertical projection of the coil of the shielded circuit 230A (the spiral inductor) on the substrate 200. In a top view as shown in FIG. 1, an outer edge of the coil of the shielded circuit 230A (the spiral inductor) is around the solid rib portion 222. In addition, the vertical projection of the coil of the shielded circuit 230A on the substrate 200 may surround portions of the teeth 224-1 to 224-4 of the comb-shaped ground shield structure 220.

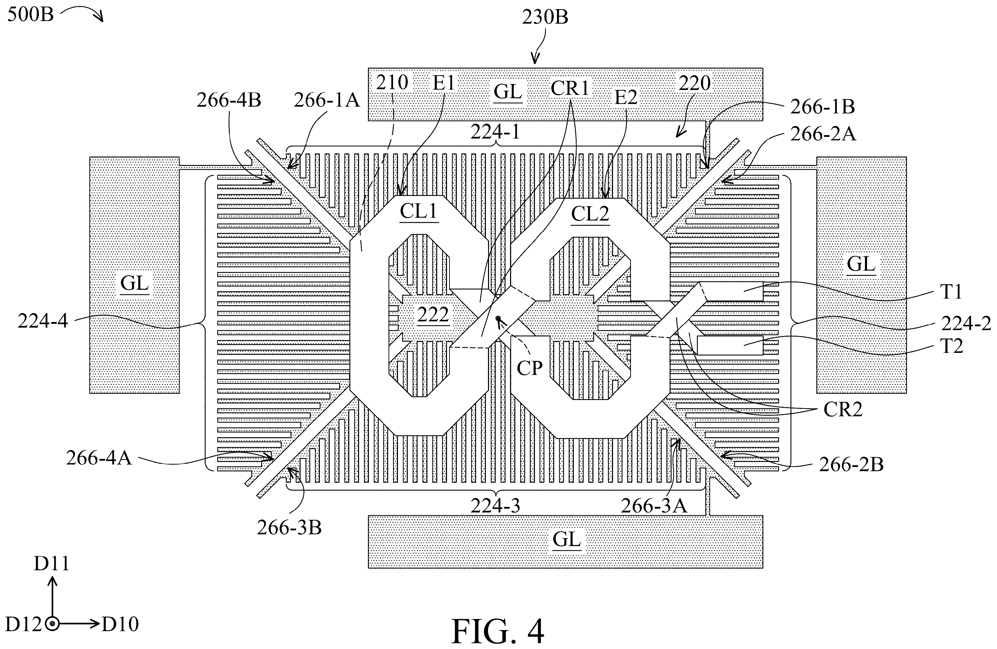

FIG. 4 is a schematic top view of an integrated circuit structure 500B in accordance with some embodiments of the disclosure. Elements of the embodiments hereinafter, that are the same or similar as those previously described with reference to FIGS. 1 and 2, are not repeated for brevity. As shown in FIGS. 1 and 4, the difference between the integrated circuit structure 500A and the integrated circuit structure 500B at least includes that a shielded circuit 230B of the integrated circuit structure 500B is an 8-shaped inductor.

As shown in FIG. 4, the shielded circuit 230B including at least one conductive line may include coils CL1 and CL2, crossings CR1 and CR2, and terminals T1 and T2. The crossing CR1 is located between the coils L1 and L2. The crossing CR2 is located between the coil CL2 and the terminals T1 and T2. The coils CL1 and CL2 may be located at the same level. The coils CL1 and CL2 and the crossings CR1 and CR2 may be located at different levels.

In some embodiments, a vertical projection of the central point CP of the central portion 222 on the substrate 200 is located within a vertical projection of the coils CL1 and CL2 of the shielded circuit 230B (the 8-shaped inductor) on the substrate 200.

In some embodiments, in the top view as shown in FIG. 4, outer edges E1 and E2 of the coils CL1 and CL2 of the shielded circuit 230B (e.g., the 8-shaped inductor) the inductor are around the central portion 222 of the patterned ground shield structure 220.

In some embodiments, in the top view as shown in FIG. 4, the crossing CR1 may overlap the central portion 222. In addition, each of the coils L1 and L2 of the shielded circuit 230B on the substrate 200 may surround portions of any two of the branches 224-1 to 224-4 of the patterned ground shield structure 220 in the top view (FIG. 4). For example, the coil L1 may surround portions of the branches 224-1 to 224-3. The coil L2 may surround portions of the branches 224-1, 224-3 and 224-4.

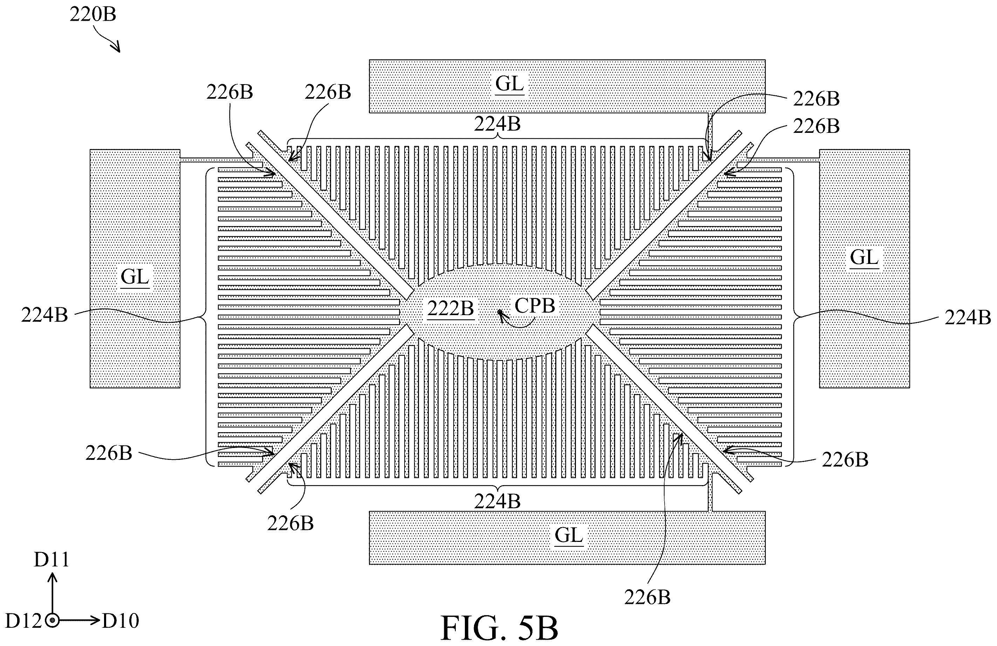

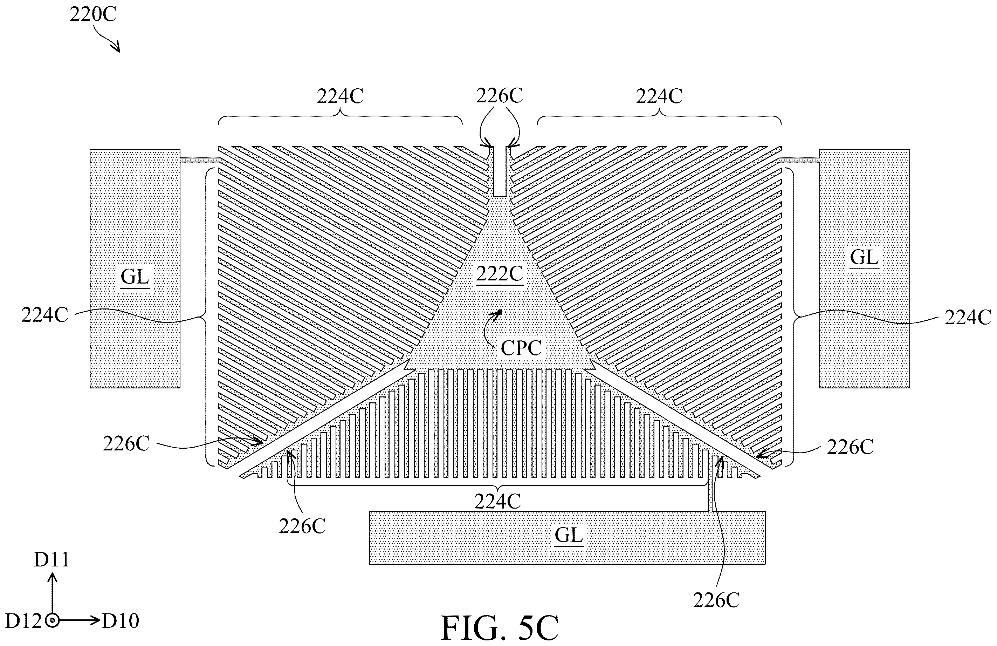

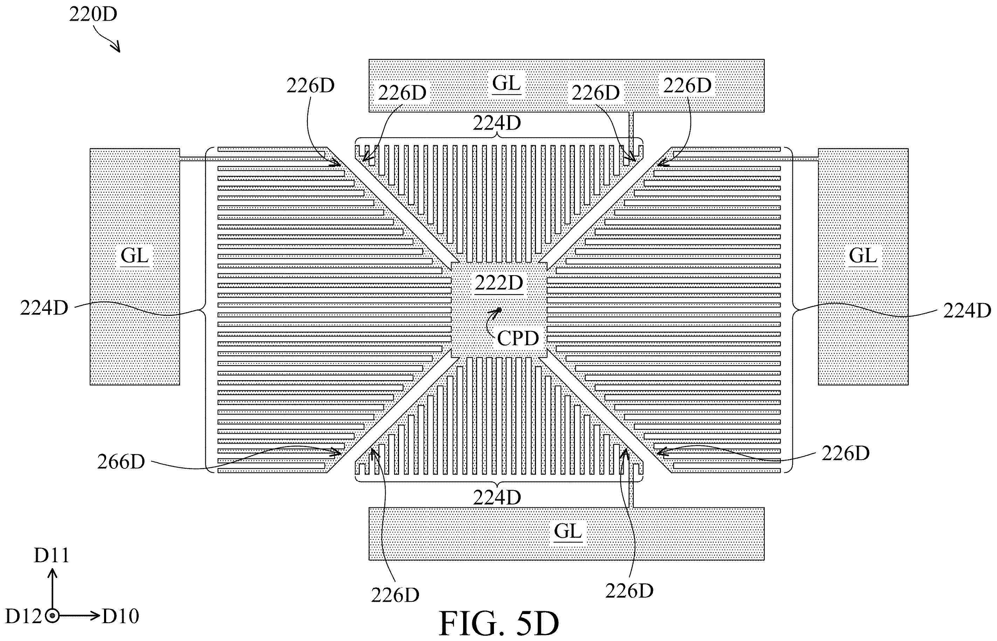

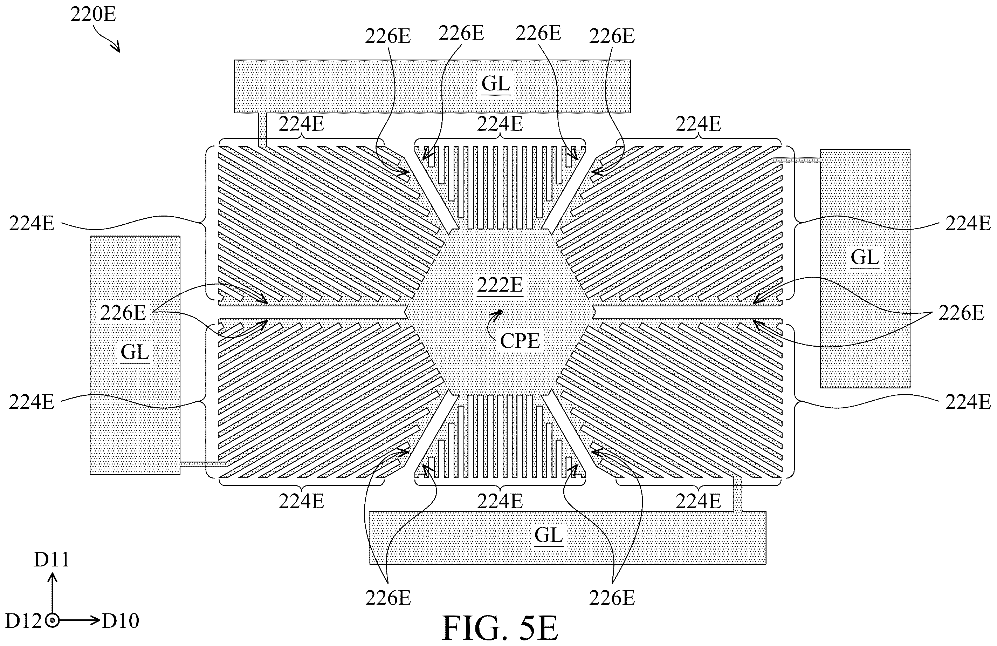

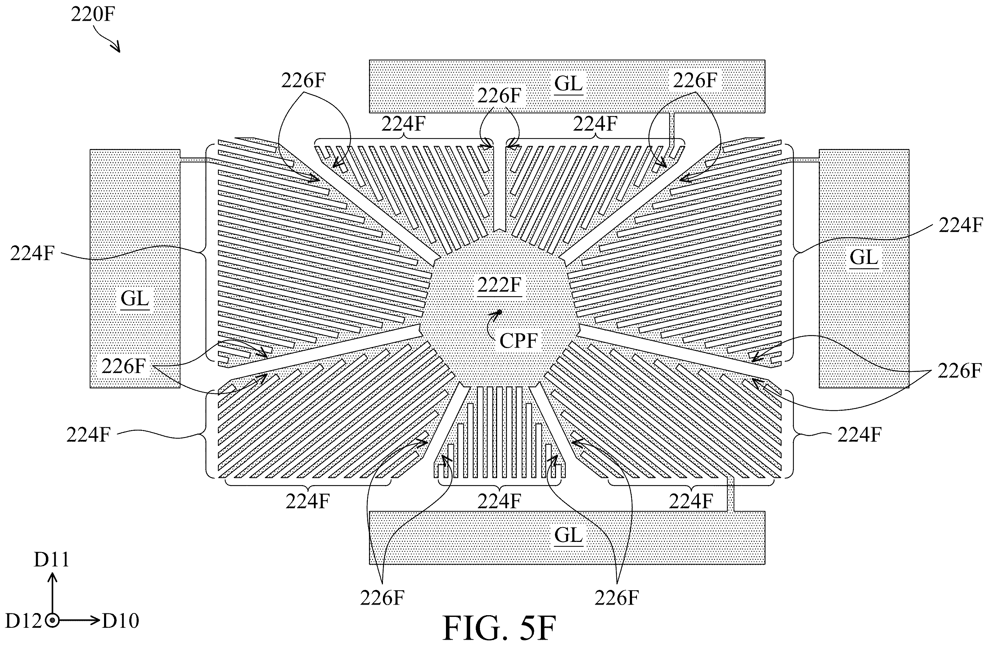

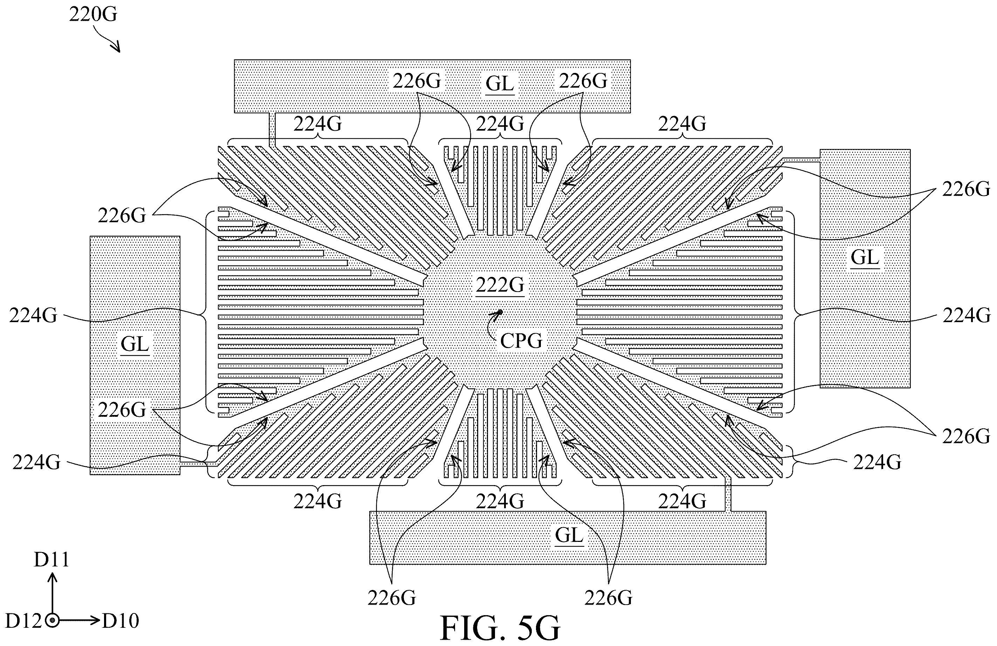

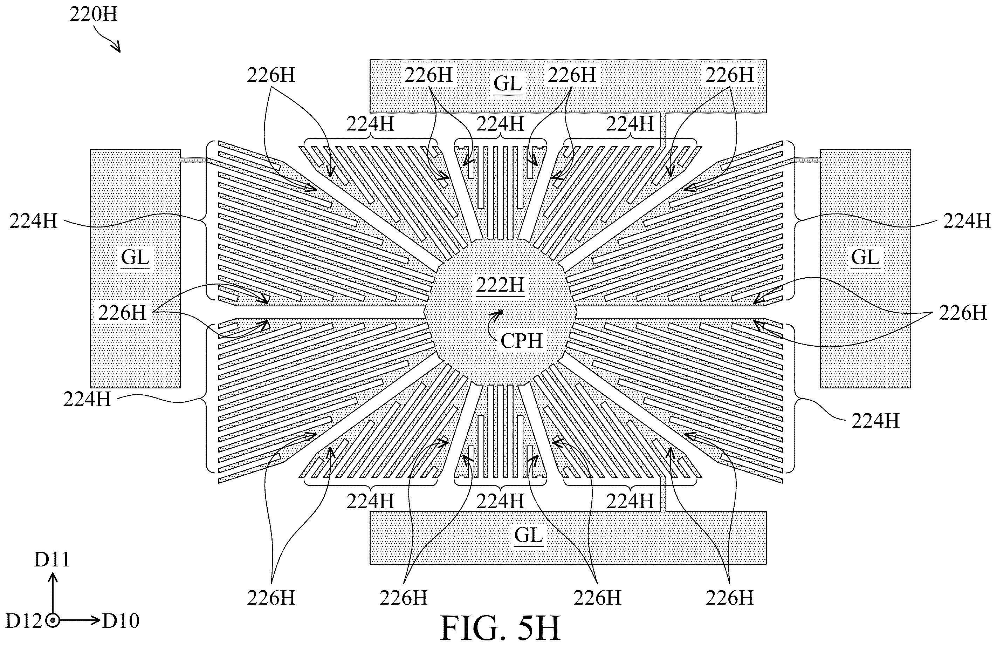

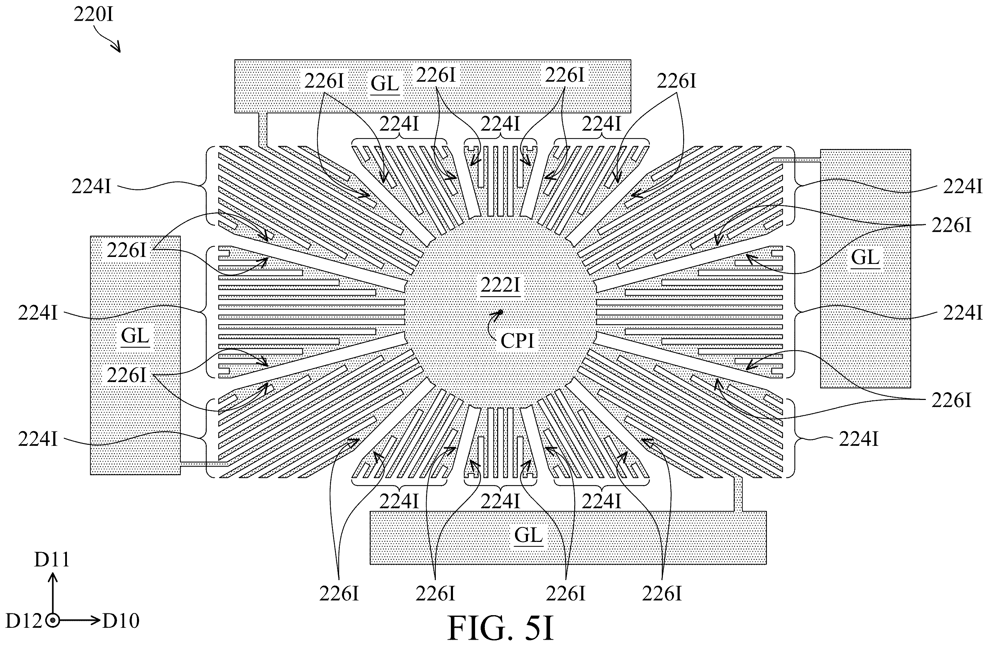

FIGS. 5A to 5I are schematic top views of patterned ground shield structures 220A, 220B, 220C, 220D, 220E, 220F, 220G, 220H, and 220I of the integrated circuit structure 500A (or the integrated circuit structure 500B) in accordance with some embodiments of the disclosure. In some other embodiments, the central portion 222A may have a circular shape (e.g., the circular central portion 222A shown in FIG. 5A), an oval shape (e.g., the oval central portion 222B shown in FIG. 5B), or a polygonal shape (e.g., the triangle central portion 222C shown in FIG. 5C, the square central portion 222D shown in FIG. 5D, the rectangular central portion 222 shown in FIG. 3, the hexagonal central portion 222E shown in FIG. 5E, the heptagonal central portion 222F shown in FIG. 5F, the octagonal central portion 222G shown in FIG. 5G, the decagonal central portion 222H shown in FIG. 5H, the dodecagonal central portion 222I shown in FIG. 5I). However, the shape of the central portion 222 is not limited to the disclosed embodiment.

In some embodiments in which the patterned ground shield structure 220A having the circular central portion 222A, branches 224A substantially extend radially from the central point CPA of the circular central portion 222A and surround the circular central portion 222A. In some embodiments in which the patterned ground shield structure 220B having the oval central portion 222B, branches 224B substantially extend radially from the central point CPB of the oval central portion 222B and surround the oval central portion 222B.

In addition, the patterned ground shield structure having the circular or oval central portion may further include supporting bars (e.g., the supporting bars 226A and 226B) connected to the central portion. The supporting bars may divide the branches (e.g., the branches 224A and 224B) into at least two groups. At least one of the supporting bars is coupled to a ground layer (not shown).

In some embodiments in which the patterned ground shield structure (e.g., the patterned ground shield structures 220C, 220D, 220E, 220F, 220G, 220H, and 220I) having the polygonal central portion (e.g., the triangle central portion 222C, the square central portion 222D, the rectangular central portion 222 (FIG. 3), the hexagonal central portion 222E, the heptagonal central portion 222F, the octagonal central portion 222G, and the decagonal central portion 222H, and the dodecagonal central portion 222I), groups of branches (e.g., the branches 224C, 224D, 224E, 224F, 224G, 224H, and 224I) may substantially extend radially from the central point (e.g., the central point CPC, CPD, CPE, CPF, CPG, CPH, and CPI) of the corresponding central portion (e.g., the 222C, 222D, 222E, 222F, 222G, 222H, and 222I) and surround the corresponding central. In addition, groups of branches (e.g., the branches 224C, 224D, 224E, 224F, 224G, and 224I) are arranged on the corresponding sides of the polygonal central portions and extending outward from the corresponding polygonal central portions.

In addition, the patterned ground shield structure having the polygonal central portion may further include supporting bars (e.g., the supporting bars 226C, 226D, 226E, 226F, 226G, 226H, and 226I) are connected to the corresponding corners and substantially parallel to the internal angle bisector of the corresponding corners. The branches not overlapping the side of the central portion are connected to the corresponding supporting bars
Embodiments provide an integrated circuit structure. The integrated circuit structure includes a substrate, a patterned ground shield structure, a shielded circuit, and an aggressor circuit. The patterned ground shield structure has a special pattern (including a central portion and groups of branches connected to the central portion) of a conductive layer that can be placed near to the shielded circuit. The patterned ground shield structure can effectively prevent the shielded circuit from the EM coupling. In some embodiments, the top view area of the central portion is designed to be smaller than the top view area of the shielded circuit. Therefore, eddy current is hardly generated in the patterned ground shield structure, and the shielded circuit may maintain its quality factor. When the circuit size is continuously shrunk, the integrated circuit structure (especially the shielded circuit) may still have high Q performance.

Embodiments of the present disclosure provide an integrated circuit structure. The integrated circuit structure includes a substrate, a patterned ground shield structure, and a shielded circuit. The patterned ground shield structure is disposed above the substrate. The patterned ground shield structure includes a central portion and branches. The branches are connected to the central portion. The branches substantially extend radially from the central point of the central portion and surround the central portion. The shielded circuit including at least one conductive line is located directly above the patterned ground shield structure.

In some embodiments, the branches include a group of first branches and a group of second branches. The group of first branches is arranged on a first side of the central portion and extending outward from the central portion. The group of second branches is arranged on a second side of the central portion and extending outward away from the central portion.

In some embodiments, the first branches are parallel each other, and the second branches are parallel each other.

In some embodiments, the angle between an extending direction of the first branches and an extending direction of the first side of the central portion is greater than zero degree and less than 180 degrees.

In some embodiments, an angle between an extending direction of the first branches and an extending direction of the second branches corresponds to an angle between the first side and the second side of the central portion.

In some embodiments, the first branches directly connected to the first side of the central portion and the second branches overlapping the second side of the central portion have different lengths.

In some embodiments, the first side of the central portion is located between a first corner and a second corner of the central portion. The patterned ground shield structure further includes a first supporting bar and a second supporting bar. The first supporting bar is connected to and extending outward from the first corner of the central portion. The second supporting bar is connected to and extending outward from the second corner of the central portion. The first branches not overlapping the first side of the central portion are connected to the first supporting bar or the second supporting bar.

In some embodiments, an angle between the first and second supporting bars is greater than zero degrees and less than 90 degrees.

In some embodiments, lengths of the first branches connected to the first supporting bar or the second supporting bar are gradually changed.

In some embodiments, at least one of the first and second supporting bars is coupled to a ground layer.

In some embodiments, the ground shield structure and the ground layer are located at different levels.

In some embodiments, the second side of central portion is located between the second corner and a third corner of the central portion. The patterned ground shield structure further includes a third supporting bar and a fourth supporting bar. The third supporting bar is connected to and extending outward from the second corner of the central portion. The fourth supporting bar is connected to and extending outward from the third corner of the central portion. The second branches not overlapping the second side of the central portion are connected to the third supporting bar or the fourth supporting bar.

In some embodiments, the second supporting bar is separated from and parallel to the third supporting bar.

In some embodiments, the central portion has a circular shape, an oval shape, or a polygonal shape.

In some embodiments, the patterned ground shield structure further includes a group of third branches. The group of third branches is arranged on a third side of the central portion and extending outward from the central portion. The second side is located between the first and third side.

In some embodiments, the integrated circuit structure further includes an aggressor circuit disposed on the substrate and located directly below the patterned ground shield structure, in a top view, an area of the central portion is smaller than an area of the aggressor circuit.

In some embodiments, the shielded circuit includes an inductor, and the aggressor circuit includes an inductive circuit.

In some embodiments, a vertical projection of the central point of the central portion on the substrate is located within a vertical projection of a coil of the inductor on the substrate.

Embodiments of the present disclosure provide an integrated circuit structure. The integrated circuit structure includes a substrate, a comb-shaped ground shield structure, an aggressor circuit, and a shielded circuit. The comb-shaped ground shield structure disposed above the substrate. The comb-shaped ground shield structure includes a solid rib portion, first teeth and second teeth. The first teeth are arranged on a first side of the solid rib portion. The second teeth are arranged on a second side of the solid rib portion. The aggressor circuit is disposed on the substrate and located directly below the patterned ground shield structure. The shielded circuit is located directly above the patterned ground shield structure. In a top view, an edge of a coil of the shielded circuit is around the solid rib portion.

In some embodiments, the first side of the solid rib portion is located between a first corner and a second corner of the central portion. The comb-shaped ground shield structure further includes a first supporting bar and a second supporting bar. The first supporting bar is connected to the first corner and substantially parallel to an internal angle bisector of the first corner. The second supporting bar is connected to the second corner and substantially parallel to an internal angle bisector of the second corner. The first branches not overlapping the first side of the solid rib portion are connected to the first supporting bar or the second supporting bar.

While the disclosure has been described by way of example and in terms of the preferred embodiments, it should be understood that the disclosure is not limited to the disclosed embodiments. On the contrary, it is intended to cover various modifications and similar arrangements. Therefore, the scope of the appended claims should be accorded the broadest interpretation so as to encompass all such modifications and similar arrangements.

Embodiments of the invention are set out in the following numbered Embodiments of the invention are set out in the following numbered clauses:
Clause 1. An integrated circuit structure, comprising a substrate; a patterned ground shield structure disposed above the substrate, wherein the patterned ground shield structure comprises: a central portion; and branches connected to the central portion, wherein the branches substantially extend radially from a central point of the central portion and surround the central portion; and a shielded circuit comprising at least one conductive line located directly above the patterned ground shield structure.
Clause 2. The integrated circuit structure of clause 1, wherein the branches comprise: a group of first branches arranged on a first side of the central portion and extending outward from the central portion; and a group of second branches arranged on a second side of the central portion and extending outward away from the central portion.
Clause 3. The integrated circuit structure of clause 2, wherein the first branches are parallel each other, and the second branches are parallel each other.
Clause 4. The integrated circuit structure of clause 2, wherein an angle between an extending direction of the first branches and an extending direction of the first side of the central portion is greater than zero degrees and less than 180 degrees.
Clause 5. The integrated circuit structure of clause 2, wherein an angle between an extending direction of the first branches and an extending direction of the second branches corresponds to an angle between the first side and the second side of the central portion.
Clause 6. The integrated circuit structure of clause 2, wherein the first branches directly connected to the first side of the central portion and the second branches overlapping the second side of the central portion have different lengths.
Clause 7. The integrated circuit structure of clause 2, wherein the first side of the central portion is located between a first corner and a second corner of the central portion, and the patterned ground shield structure further comprises: a first supporting bar connected to the central portion close to the first corner and extending outward from the central portion; and a second supporting bar connected to the central portion close to the second corner and extending outward from the central portion, wherein the first branches not overlapping the first side of the central portion are connected to the first supporting bar or the second supporting bar.
Clause 8. The integrated circuit structure of clause 7, wherein an angle between the first and second supporting bars is greater than zero degrees and less than 90 degrees.
Clause 9. The integrated circuit structure of clause 7, wherein lengths of the first branches connected to the first supporting bar or the second supporting bar are gradually changed.
Clause 10. The integrated circuit structure of clause 7, wherein at least one of the first and second supporting bars is coupled to a ground layer.
Clause 11. The integrated circuit structure of clause 10, wherein the ground shield structure and the ground layer are located at different levels.
Clause 12. The integrated circuit structure of clause 7, wherein the second side of central portion is located between the second corner and a third corner of the central portion, and the patterned ground shield structure further comprises: a third supporting bar connected to the central portion close to the second corner and extending substantially outward from the central portion; and a fourth supporting bar connected to the central portion close to the third corner and extending outward from the central portion, wherein the second branches not overlapping the second side of the central portion are connected to the third supporting bar or the fourth supporting bar.
Clause 13. The integrated circuit structure of clause 12, wherein the second supporting bar is separated from and parallel to the third supporting bar.
Clause 14. The integrated circuit structure of clause 1, wherein the central portion has a circular shape, an oval shape, or a polygonal shape.
Clause 15. The integrated circuit structure of clause 2, wherein the patterned ground shield structure further comprises: a group of third branches arranged on a third side of the central portion and extending outward from the central portion, wherein the second side is located between the first and third sides.
Clause 16. The integrated circuit structure of clause 1, further comprising: an aggressor circuit disposed on the substrate and located directly below the patterned ground shield structure, wherein in a top view, an area of the central portion is smaller than an area of the aggressor circuit.
Clause 17. The integrated circuit structure of clause 16, wherein the shielded circuit comprises an inductor, and the aggressor circuit comprises an inductive circuit.
Clause 18. The integrated circuit structure of clause 1, wherein a vertical projection of the central point of the central portion on the substrate is located within a vertical projection of a coil of the inductor on the substrate.
Clause 19. An integrated circuit structure, comprising: a substrate; and a comb-shaped ground shield structure disposed above the substrate, wherein the comb-shaped ground shield structure comprises: a solid rib portion; first teeth arranged on a first side of the solid rib portion; and second teeth arranged on a second side of the solid rib portion; and a shielded circuit located directly above the patterned ground shield structure, wherein in a top view, an edge of a coil of the shielded circuit is around the solid rib portion.
Clause 20. The integrated circuit structure of clause 19, wherein the first side of the solid rib portion is located between a first corner and a second corner of the central portion, and the comb-shaped ground shield structure further comprises: a first supporting bar connected to the central portion close to the first corner and substantially parallel to an internal angle bisector of the first corner; and a second supporting bar connected to the central portion close to the second corner and substantially parallel to an internal angle bisector of the second corner, wherein the first branches not overlapping the first side of the solid rib portion are connected to the first supporting bar or the second supporting bar.

## Claims

1. An integrated circuit structure (500A, 500B), comprising:
a substrate (200);
a patterned ground shield structure (220, 220A, 220B, 220C, 220D, 220E, 220F, 220G, 220H, 220I) disposed above the substrate (200), wherein the patterned ground shield structure comprises:
a central portion (222, 222A, 222B, 222C, 222D, 222E, 222F, 222G, 222H, 222I); and
branches (224-1, 224-2, 224-3, 224-4, 224A, 224B, 224C, 224D, 224E, 224F, 224G, 224H, 224I) connected to the central portion (222, 222A, 222B, 222C, 222D, 222E, 222F, 222G, 222H, 222I), wherein the branches (224-1, 224-2, 224-3, 224-4, 224A, 224B, 224C, 224D, 224E, 224F, 224G, 224H, 224I) substantially extend radially from a central point (CP, CPA, CPB, CPC, CPD, CPE, CPF, CPG, CPH, CPI) of the central portion (222, 222A, 222B, 222C, 222D, 222E, 222F, 222G, 222H, 222I) and surround the central portion (222, 222A, 222B, 222C, 222D, 222E, 222F, 222G, 222H, 222I); and
an shielded circuit (230A, 230B) comprising at least one conductive line located directly above the patterned ground shield structure (220, 220A, 220B, 220C, 220D, 220E, 220F, 220G, 220H, 220I).

2. The integrated circuit structure (500A, 500B) as claimed in claim 1, wherein the branches comprise:
a group of first branches (224-1, 224-2, 224-3, 224-4, 224C, 224D, 224E, 224F, 224G, 224H, 224I) arranged on a first side (222S1, 222S2, 222S3, 222S4) of the central portion (222, 222A, 222B, 222C, 222D, 222E, 222F, 222G, 222H, 222I) and extending outward from the central portion (222, 222A, 222B, 222C, 222D, 222E, 222F, 222G, 222H, 222I); and
a group of second branches (224-1, 224-2, 224-3, 224-4, 224C, 224D, 224E, 224F, 224G, 224H, 224I) arranged on a second side (22251, 222S2, 222S3, 222S4) of the central portion (222, 222A, 222B, 222C, 222D, 222E, 222F, 222G, 222H, 222I) and extending outward away from the central portion (222, 222A, 222B, 222C, 222D, 222E, 222F, 222G, 222H, 222I).

3. The integrated circuit structure (500A, 500B) as claimed in claim 2, wherein the first branches (224-1, 224-2, 224-3, 224-4, 224C, 224D, 224E, 224F, 224G, 224H, 224I) are parallel each other, and the second branches (224-1, 224-2, 224-3, 224-4, 224C, 224D, 224E, 224F, 224G, 224H, 224I) are parallel each other.

4. The integrated circuit structure (500A, 500B) as claimed in claim 2, wherein an angle (AC1, AC2, AC3, AC4) between an extending direction (D10, D11) of the first branches (224-1, 224-2, 224-3, 224-4, 224C, 224D, 224E, 224F, 224G, 224H, 224I) and an extending direction (D10, D11) of the first side (222S1, 222S2, 222S3, 222S4) of the central portion (222, 222A, 222B, 222C, 222D, 222E, 222F, 222G, 222H, 222I) is greater than zero degrees and less than 180 degrees.

5. The integrated circuit structure (500A, 500B) as claimed in claim 2, wherein an angle between an extending direction (D10, D11) of the first branches (224-1, 224-2, 224-3, 224-4, 224C, 224D, 224E, 224F, 224G, 224H, 224I) and an extending direction (D10, D11) of the second branches (224-1, 224-2, 224-3, 224-4, 224C, 224D, 224E, 224F, 224G, 224H, 224I) corresponds to an angle between the first side (222S1, 222S2, 222S3, 222S4) and the second side (22251, 222S2, 222S3, 222S4) of the central portion (222, 222A, 222B, 222C, 222D, 222E, 222F, 222G, 222H, 222I).

6. The integrated circuit structure (500A, 500B) as claimed in claim 2, wherein the first branches (224-1, 224-2, 224-3, 224-4, 224C, 224D, 224E, 224F, 224G, 224H, 224I) directly connected to the first side (222S1, 222S2, 222S3, 222S4) of the central portion (222, 222A, 222B, 222C, 222D, 222E, 222F, 222G, 222H, 222I) and the second branches (224-1, 224-2, 224-3, 224-4, 224C, 224D, 224E, 224F, 224G, 224H, 224I) overlapping the second side (22251, 222S2, 222S3, 222S4) of the central portion (222, 222A, 222B, 222C, 222D, 222E, 222F, 222G, 222H, 222I) have different lengths.

7. The integrated circuit structure (500A, 500B) as claimed in claim 2, wherein the first side (222S1, 222S2, 222S3, 222S4) of the central portion (222, 222A, 222B, 222C, 222D, 222E, 222F, 222G, 222H, 222I) is located between a first corner (C1, C2, C3, C4) and a second corner (C2, C3, C4, C1) of the central portion (222, 222A, 222B, 222C, 222D, 222E, 222F, 222G, 222H, 222I), and the patterned ground shield structure (220, 220A, 220B, 220C, 220D, 220E, 220F, 220G, 220H, 220I) further comprises:
a first supporting bar (266-1A, 266-1B, 266-2A, 266-2B, 266-3A, 266-3B, 266-4A, 266-4B, 226C, 226D, 226E, 226F, 226G, 226H, 226I) connected to the central portion (222, 222A, 222B, 222C, 222D, 222E, 222F, 222G, 222H, 222I) close to the first corner (C1, C2, C3, C4) and extending outward from the central portion (222, 222A, 222B, 222C, 222D, 222E, 222F, 222G, 222H, 222I); and
a second supporting bar (266-1A, 266-1B, 266-2A, 266-2B, 266-3A, 266-3B, 266-4A, 266-4B, 226C, 226D, 226E, 226F, 226G, 226H, 226I) connected to the central portion (222, 222A, 222B, 222C, 222D, 222E, 222F, 222G, 222H, 222I) close to the second corner (C2, C3, C4, C1) and extending outward from the central portion (222, 222A, 222B, 222C, 222D, 222E, 222F, 222G, 222H, 222I), wherein the first branches (224-1, 224-2, 224-3, 224-4, 224C, 224D, 224E, 224F, 224G, 224H, 224I) not overlapping the first side (222S1, 222S2, 222S3, 222S4) of the central portion (222, 222A, 222B, 222C, 222D, 222E, 222F, 222G, 222H, 222I) are connected to the first supporting bar (266-1A, 266-1B, 266-2A, 266-2B, 266-3A, 266-3B, 266-4A, 266-4B, 226C, 226D, 226E, 226F, 226G, 226H, 226I) or the second supporting bar (266-1A, 266-1B, 266-2A, 266-2B, 266-3A, 266-3B, 266-4A, 266-4B, 226C, 226D, 226E, 226F, 226G, 226H, 226I).

8. The integrated circuit structure (500A, 500B) as claimed in claim 7, wherein an angle (226A1, 226A2, 226A3, 226A4) between the first and second supporting bars (266-1A, 266-1B, 266-2A, 266-2B, 266-3A, 266-3B, 266-4A, 266-4B, 226C, 226D, 226E, 226F, 226G, 226H, 226I) is greater than zero degrees and less than 90 degrees.

9. The integrated circuit structure (500A, 500B) as claimed in claim 7, wherein lengths (L1, L2, L3, L4) of the first branches (224-1, 224-2, 224-3, 224-4, 224C, 224D, 224E, 224F, 224G, 224H, 224I) connected to the first supporting bar (266-1A, 266-1B, 266-2A, 266-2B, 266-3A, 266-3B, 266-4A, 266-4B, 226C, 226D, 226E, 226F, 226G, 226H, 226I) or the second supporting bar (266-1A, 266-1B, 266-2A, 266-2B, 266-3A, 266-3B, 266-4A, 266-4B, 226C, 226D, 226E, 226F, 226G, 226H, 226I) are gradually changed.

10. The integrated circuit structure (500A, 500B) as claimed in claim 7, wherein at least one of the first and second supporting bars (266-1A, 266-1B, 266-2A, 266-2B, 266-3A, 266-3B, 266-4A, 266-4B, 226C, 226D, 226E, 226F, 226G, 226H, 226I) is coupled to a ground layer (GL),
optionally wherein the ground shield structure (220, 220A, 220B, 220C, 220D, 220E, 220F, 220G, 220H, 220I) and the ground layer (GL) are located at different levels.

11. The integrated circuit structure (500A, 500B) as claimed in claim 7, wherein the second side (222S1, 222S2, 222S3, 222S4) of central portion (222, 222A, 222B, 222C, 222D, 222E, 222F, 222G, 222H, 222I) is located between the second corner (C2, C3, C4, C1) and a third corner (C3, C4, C1, C2) of the central portion (222, 222A, 222B, 222C, 222D, 222E, 222F, 222G, 222H, 222I), and the patterned ground shield structure (220, 220A, 220B, 220C, 220D, 220E, 220F, 220G, 220H, 220I) further comprises:
a third supporting bar (266-1A, 266-1B, 266-2A, 266-2B, 266-3A, 266-3B, 266-4A, 266-4B, 226C, 226D, 226E, 226F, 226G, 226H, 226I) connected to the central portion (222, 222A, 222B, 222C, 222D, 222E, 222F, 222G, 222H, 222I) close to the second corner (C2, C3, C4, C1) and extending substantially outward from the central portion (222, 222A, 222B, 222C, 222D, 222E, 222F, 222G, 222H, 222I); and
a fourth supporting bar (266-1A, 266-1B, 266-2A, 266-2B, 266-3A, 266-3B, 266-4A, 266-4B, 226C, 226D, 226E, 226F, 226G, 226H, 226I) connected to the central portion (222, 222A, 222B, 222C, 222D, 222E, 222F, 222G, 222H, 222I) close to the third corner (C3, C4, C1, C2) and extending outward from the central portion (222, 222A, 222B, 222C, 222D, 222E, 222F, 222G, 222H, 222I), wherein the second branches (224-1, 224-2, 224-3, 224-4, 224C, 224D, 224E, 224F, 224G, 224H, 224I) not overlapping the second side (222S1, 222S2, 222S3, 222S4) of the central portion (222, 222A, 222B, 222C, 222D, 222E, 222F, 222G, 222H, 222I) are connected to the third supporting bar (222, 222A, 222B, 222C, 222D, 222E, 222F, 222G, 222H, 222I) or the fourth supporting bar (222, 222A, 222B, 222C, 222D, 222E, 222F, 222G, 222H, 222I),
optionally wherein the second supporting bar (266-1A, 266-1B, 266-2A, 266-2B, 266-3A, 266-3B, 266-4A, 266-4B, 226C, 226D, 226E, 226F, 226G, 226H, 226I) is separated from and parallel to the third supporting bar (266-1A, 266-1B, 266-2A, 266-2B, 266-3A, 266-3B, 266-4A, 266-4B, 226C, 226D, 226E, 226F, 226G, 226H, 226I).

12. The integrated circuit structure (500A, 500B) as claimed in any one of claims 1 to 11, wherein the central portion (222, 222A, 222B, 222C, 222D, 222E, 222F, 222G, 222H, 222I) has a circular shape, an oval shape, or a polygonal shape.

13. The integrated circuit structure (500A, 500B) as claimed in claim 2, wherein the patterned ground shield structure (220, 220A, 220B, 220C, 220D, 220E, 220F, 220G, 220H, 220I) further comprises:
a group of third branches (224-1, 224-2, 224-3, 224-4, 224C, 224D, 224E, 224F, 224G, 224H, 224I) arranged on a third side (22251, 222S2, 222S3, 222S4) of the central portion (222, 222A, 222B, 222C, 222D, 222E, 222F, 222G, 222H, 222I) and extending outward from the central portion (222, 222A, 222B, 222C, 222D, 222E, 222F, 222G, 222H, 222I), wherein the second side (222S1, 222S2, 222S3, 222S4) is located between the first and third sides (22251, 222S2, 222S3, 222S4).

14. The integrated circuit structure (500A, 500B) as claimed in any one of claims 1 to 13, further comprising:
a aggressor circuit (210) disposed on the substrate and located directly below the patterned ground shield structure (220, 220A, 220B, 220C, 220D, 220E, 220F, 220G, 220H, 220I), wherein in a top view, an area of the central portion (222, 222A, 222B, 222C, 222D, 222E, 222F, 222G, 222H, 222I) is smaller than an area of the aggressor circuit (210),
optionally wherein the shielded circuit (230A, 230B) comprises an inductor, and the aggressor circuit (210) comprises an inductive circuit.

15. The integrated circuit structure (500A, 500B) as claimed in any one of claims 1 to 14, wherein a vertical projection of the central point (CP, CPA, CPB, CPC, CPD, CPE, CPF, CPG, CPH, CPI) of the central portion (222, 222A, 222B, 222C, 222D, 222E, 222F, 222G, 222H, 222I) on the substrate (200) is located within a vertical projection of a coil (CL1, CL2) of the inductor (230A, 230B) on the substrate (200).
